# EUROPEAN PATENT APPLICATION

(11) **EP 4 123 695 A1**
(43) Date of publication of application: **25.01.2023**
(21) Application number: 20927593.2
(22) Date of filing: 25.03.2020
(51) Int. Cl.: H01L 23/02, H01L 21/50

(54) **MEMORY CHIP STACKED PACKAGE AND ELECTRONIC DEVICE**

(71) Applicant: Huawei Technologies Co., Ltd., Shenzhen, Guangdong 518129 (CN)
(72) Inventor: JIAO, Huifang, Shenzhen, Guangdong 518129 (CN); HE, Ran, Shenzhen, Guangdong 518129 (CN); LI, Wei, Shenzhen, Guangdong 518129 (CN); LIU, Jingxia, Shenzhen, Guangdong 518129 (CN); LI, Tan, Shenzhen, Guangdong 518129 (CN)
(74) Representative: Gill Jennings & Every LLP
(86) International application number: PCT/CN2020/081132
(87) International publication number: WO 2021/189300

(57) **Abstract**

This application provides a memory chip stacking package and an electronic device, to avoid high manufacturing costs caused by use of a technology such as a micro-bump in combination with a TSV, or an RDL. The memory chip stacking package includes a substrate and a plurality of layers of memory chips sequentially stacked on the substrate. The plurality of layers of memory chips include a first memory chip and a second memory chip located at a first layer, a third memory chip and a fourth memory chip located at a second layer, and a fifth memory chip located at a third layer. A first window and a second window are provided at locations, on the substrate, that corresponds to the first memory chip and the second memory chip. The first memory chip and the second memory chip are directly connected to the substrate. The third memory chip and the fourth memory chip are connected to the substrate through wire bonding. The fifth memory chip is bonded to the third memory chip and the fourth memory chip. The fifth memory chip is connected to the substrate through wire bonding.

## Description

### TECHNICAL FIELD

This application relates to the field of semiconductor technologies, and in particular, to a multi memory chip stacking package and an electronic device.

### BACKGROUND

With development of high-performance computers and portable electronic apparatuses, more chips need to be integrated in a small area of a circuit board, and therefore a more compact physical layout method for chips also gains development. A multi-chip stacking packaging method can effectively reduce an area of a circuit board and has become a mainstream mode of memory chip packaging in many portable apparatuses. For example, in a smartphone, a plurality of dynamic random access memory (dynamic random access memory, DRAM) chips sharing an I/O (input/output, input/output) port are stacked and packaged together and then arranged on a printed circuit board. The chips are interconnected with a central processing unit (central processing unit, CPU) of the mobile phone through the shared I/O port, to constitute a high-speed microprocessor-memory system.

On the premise of ensuring that an area of a DRAM chip stacking package meets a requirement, in some DRAM chip stacking packages, DRAM chips are stacked with large-area overlapping, and contacts of the chips are connected to a substrate through micro-bumps (micro-bump) in combination with through silicon vias (through silicon via, TSV); and in some DRAM chip stacking packages, an additional redistribution layer (redistribution layer, RDL) is added to redistribute center contacts of chips to both ends. All these arrangement manners increase costs of the chip stacking packages.

### SUMMARY

This application provides a memory chip stacking package and an electronic device. On the basis that an area meets a requirement, the memory chip stacking package can avoid high manufacturing costs caused by use of a micro-bump (micro-bump) in combination with a through silicon via (TSV), a redistribution layer (RDL), or the like.

An embodiment of this application provides a memory chip stacking package, including a substrate and a plurality of layers of memory chips sequentially stacked on the substrate. The plurality of layers of memory chips include a first memory chip and a second memory chip that are disposed in parallel at a first layer, a third memory chip and a fourth memory chip that are disposed in parallel at a second layer, and a fifth memory chip located at a third layer. Active surfaces of the first memory chip and the second memory chip face an upper surface of the substrate, and passive surfaces of the third memory chip and the fourth memory chip are attached to passive surfaces of the first memory chip and the second memory chip respectively. Contacts on the active surfaces of the first memory chip and the second memory chip are connected to the substrate. Contacts on active surfaces of the third memory chip and the fourth memory chip are connected to the substrate through wire bonding. A passive surface of the fifth memory chip is bonded to the active surfaces of the third memory chip and the fourth memory chip. Contacts on an active surface of the fifth memory chip are connected to the substrate through wire bonding.

The memory chip stacking package includes at least five memory chips sequentially stacked at a plurality of layers. The active surfaces of the two memory chips at the first layer are arranged to face down and be directly connected to the substrate (for example, connected to the upper surface of the substrate through bumps, or connected to a lower surface of the substrate through a window on the substrate). The non-active surfaces of the two chips at the second layer are arranged to be respectively attached to upper surfaces of the two memory chips at the first layer, and the active surfaces of the two chips are arranged to be connected to the substrate through wire bonding (for example, may be connected to the upper surface of the substrate through wire bonding). The non-active surface of the memory chip at the third layer is arranged to be bonded to the two memory chips at the second layer, and the active surface of the memory chip is arranged to be connected to the substrate through wire bonding. With the memory chip stacking package in this application, on the basis of ensuring that an area of a package structure meets a requirement, interconnection between the five memory chips and the substrate can be implemented without using a connection technology such as micro-bumps in combination with TSVs or an RDL, thereby greatly reducing manufacturing costs of the memory chip stacking package.

In some possible implementations, a first window for connecting the upper surface and a lower surface of the substrate is provided at a location, on the substrate, that corresponds to the first memory chip, and a second window for connecting the upper surface and the lower surface of the substrate is provided at a location, on the substrate, that corresponds to the second memory chip. Contacts on the active surface of the first memory chip are connected to the lower surface of the first substrate through wire bonding and the first window, and contacts on the active surface of the second memory chip are connected to the lower surface of the first substrate through wire bonding and the second window, to effectively reduce manufacturing costs of the package structure.

In some possible implementations, the contacts on the active surfaces of the third memory chip and the fourth memory chip are connected to the upper surface of the substrate through wire bonding, to effectively reduce manufacturing costs of the package structure.

In some possible implementations, the active surface of the fifth memory chip faces a side away from the substrate, and the contacts on the active surface of the fifth memory chip are connected to the upper surface of the substrate through wire bonding. That is, the active surface of the memory chip disposed at the third layer faces up and is connected to the upper surface of the substrate through wire bonding, thereby ensuring wire bonding between all the memory chips and the substrate in the package structure, to reduce manufacturing costs.

In some possible implementations, the active surface of the fifth memory chip faces the upper surface of the substrate, a third window for connecting the upper surface and the lower surface of the substrate is provided in a region, on the substrate, that corresponds to the first memory chip and the second memory chip, orthographic projections of the third memory chip and the fourth memory chip on the substrate do not overlap the third window, and the contacts on the active surface of the fifth memory chip are connected to the lower surface of the substrate through wire bonding and the third window. That is, the active surface of the memory chip disposed at the third layer faces down and is connected to the lower surface of the substrate through wire bonding and a window on the substrate, thereby ensuring wire bonding between all the memory chips and the substrate in the package structure, to reduce manufacturing costs.

In some possible implementations, the plurality of layers of memory chips further include a sixth memory chip located at a fourth layer. An active surface of the sixth memory chip faces a side away from the substrate, and contacts on the active surface of the sixth memory chip are connected to the upper surface of the substrate through wire bonding. That is, on the basis that the active surface of the memory chip disposed at the third layer faces down and is connected to the lower surface of the substrate through wire bonding and a window on the substrate, the sixth memory chip located at the fourth layer is disposed and is connected to the upper surface of the substrate through wire bonding, thereby ensuring wire bonding between all the memory chips and the substrate in the package structure, to reduce manufacturing costs.

In some possible implementations, orthographic projections of the third memory chip and the first memory chip on the substrate coincide, and orthographic projections of the fourth memory chip and the second memory chip on the substrate coincide, to reduce an area of the package structure.

In some possible implementations, orthographic projections of the sixth memory chip and the fifth memory chip on the substrate coincide, to prevent the sixth memory chip from causing unnecessary blocking to another memory chip at a lower layer in subsequent wire bonding.

In some possible implementations, all the memory chips in the memory chip stacking package have same specifications, and contacts of each memory chip are located on a central axis of an active surface.

In some possible implementations, all the memory chips in the memory chip stacking package are DRAM chips.

In some possible implementations, the plurality of layers of memory chips sequentially stacked on the substrate constitute a memory module. The first memory chip and the second memory chip in the memory module are disposed in parallel along a first direction. The memory chip stacking package includes two memory modules disposed in parallel along a second direction. The second direction is perpendicular to the first direction.

In this case, in one aspect, the two memory modules are disposed in the package structure, so that the entire package structure can have an approximately square shape, thereby ensuring that stress along the first direction is balanced with that along the second direction during installation of the package structure, and reducing a risk of warpage of the package structure. In another aspect, disposing the two memory modules in the package structure is equivalent to packaging two ranks in one package structure, thereby improving integration of the package structure.

In some possible implementations, a groove structure is provided on the upper surface of the substrate, and all the memory chips located at the first layer are disposed in the groove structure, to reduce a thickness of the entire package structure.

In some possible implementations, four of the first memory chip, the second memory chip, the third memory chip, the fourth memory chip, and the fifth memory chip are configured to provide a parallel read/write access function, and the remaining one is configured to store an ECC to implement an error correcting function.

An embodiment of this application further provides an electronic device, including a CPU and the memory chip stacking package according to any one of the foregoing possible implementations. The memory chip stacking package is connected to the CPU.

In some possible implementations, a bit width of the CPU is 64 bits, four of the first memory chip, the second memory chip, the third memory chip, the fourth memory chip, and the fifth memory chip each are configured to provide a 16-bit parallel read/write access function, and the remaining one is configured to store an ECC to implement an error correcting function. In this way, it is ensured that the ECC automatically performs correction even if a data error occurs, so that the electronic device can continue to operate properly without interruption due to the error.

In some possible implementations, the sixth memory chip in the memory chip stacking package is configured to implement a chipkill function, so that the memory chip can replace a failed memory chip, to provide an error correcting method that cannot be covered by an ECC.

### BRIEF DESCRIPTION OF DRAWINGS

FIG. 1 is a schematic diagram of a structure of a memory chip according to an embodiment of this application;
FIG. 2 is a schematic plan view of a structure of a memory chip stacking package according to an embodiment of this application;
FIG. 3 is a schematic side view of a structure of a memory chip stacking package according to an embodiment of this application;
FIG. 4 is a schematic side view of a structure of a memory chip stacking package according to an embodiment of this application;
FIG. 5 is a schematic side view of a structure of a memory chip stacking package according to an embodiment of this application;
FIG. 6 is a schematic side view of a structure of a memory chip stacking package according to an embodiment of this application;
FIG. 7 is a schematic plan view of a structure of a memory chip stacking package according to an embodiment of this application;
FIG. 8 is a schematic side view of a structure of a memory chip stacking package according to an embodiment of this application; and
FIG. 9 is a schematic side view of a structure of a memory chip stacking package according to an embodiment of this application.

### DESCRIPTION OF EMBODIMENTS

To make the objectives, technical solutions, and advantages of this application clearer, the following clearly and completely describes the technical solutions of this application with reference to the accompanying drawings in this application. It is clear that the described embodiments are merely a part rather than all of embodiments of this application. All other embodiments obtained by a person of ordinary skill in the art based on embodiments of this application without creative efforts shall fall within the protection scope of this application.

In embodiments of the specification, claims, and accompanying drawings of this application, terms "first", "second", and the like are merely intended for a purpose of differentiated description, and should not be construed as an indication or an implication of relative importance, or an indication or an implication of a sequence. In addition, terms "comprise", "include", and any variants thereof are intended to cover a non-exclusive inclusion. For example, a series of steps or units are included. "Up", "down", "horizontal", "vertical", and the like are merely used with respect to orientations of components in accompanying drawings. These directional terms are relative concepts and are used for relative descriptions and clarifications, and may vary accordingly based on changes of orientations of components in the accompanying drawings.

An embodiment of this application provides an electronic device. The electronic device may be an electronic product, for example, a server, a computer, a tablet computer (portable android device, Pad), a notebook computer, or a vehicle-mounted computer. A specific form of the electronic device is not particularly limited in this embodiment of this application.

The electronic device includes a printed circuit board (printed circuit board, PCB), and a memory chip stacking package and a CPU that are disposed on the PCB. The memory chip stacking package is electrically connected to the CPU through the PCB, to implement interconnection and transmission. For example, the memory chip stacking package may be soldered to a solder pad (pad) of the PCB through a connection structure (for example, a solder ball) disposed at the bottom.

The memory chip stacking package provided in this embodiment of this application includes at least five memory chips, to avoid high costs caused by use of technologies such as a micro-bump (micro-bump), a through silicon via (TSV), and a redistribution layer (redistribution layer, RDL), on the basis of ensuring that an area of the package structure meets a requirement.

In some embodiments, all the memory chips in the memory chip stacking package have same specifications. For example, all the memory chips may be DRAM chips.

In some possible implementations, the DRAM chip may be a DDR SDRAM (double data rate synchronous dynamic random access memory, double data rate synchronous dynamic random access memory) chip, which is referred to as DDR for short, for example, DDR4 or DDR5. The following embodiments are all described by using an example in which the memory chip is a DDR.

A person skilled in the art can understand that, as an area of a memory cell (bit) continuously decreases, a margin (margin) of the memory cell also continuously decreases. Currently, a mainstream processing process for a DRAM chip is a process node of 25 nm, 20 nm, 18 nm, or the like. An increasing quantity of weak memory cells appear in the DRAM chip. As a result, during operating of the electronic device, memory signal flip (bit flip) inevitably occurs due to temperature stress, electrical stress, and the like. In addition, because a capacity of the DRAM chip evolves from 8 Gb to 16 Gb, a risk of memory signal flip caused by a soft failure also increases. Therefore, an error correcting code (error correcting code, ECC) needs to be added to a memory system of a high-speed application, to ensure secure operating of the memory system. It should be understood that the ECC is an error correcting technology that detects and corrects an error in a data operation by adding an additional bit to data. A memory error is one of major causes of a system failure. The ECC technology can tolerate an error during memory operating. Even if a data error occurs, the ECC automatically corrects the error, so that the system can continue to operate properly without interruption due to the error. When data is written to an ECC memory, an error correcting code corresponding to the written data is stored in an additional bit of the ECC memory. When the data is read, a memory controller compares the stored error correcting code with an error correcting code generated during data reading. If the read code does not match the stored code, an error bit may be determined based on the error correcting code, and then the bit is immediately corrected.

In addition, currently, a common CPU bit width is 64 bits, and four DDRs each with a bit width of 16 bits are a rank (which may also be referred to as a memory block, namely, a DRAM chipset simultaneously accessible to the CPU, or a chipset based on which the CPU needs to perform access). In this case, a fifth DRAM chip is needed to store an ECC (error correcting code) to implement an error check and correcting function. That is, a memory package structure including at least five DRAM chips needs to be used. Based on this, the memory chip stacking package provided in this embodiment of this application includes at least five memory chips, to well adapt to proper data transmission from the CPU to the DRAM chip, and further implement miniaturization of the memory system while improving performance of the memory system.

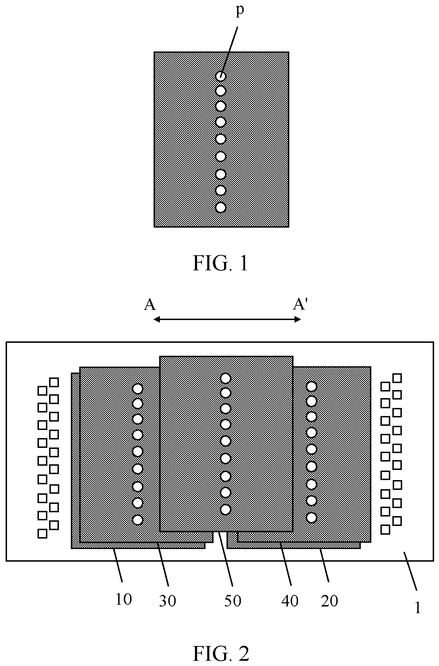

In addition, it can be further understood that the memory chip has an active surface and a non-active surface (which may also be referred to as a passive surface) that are disposed opposite to each other. The active surface of the memory chip may also be referred to as a front surface, and the non-active surface of the memory chip may also be referred to as a rear surface. Contacts (namely, conducting terminals or pads) are disposed on the active surface of the chip, and the chip is electrically connected to a substrate through the pads. For example, in a chip shown in FIG. 1, a plurality of contacts p are disposed at locations on a central axis of an active surface. All memory chips included in the following embodiments are described by using such specifications as an example.

The following further describes the memory chip stacking package provided in this application by using specific embodiments.

### Embodiment 1

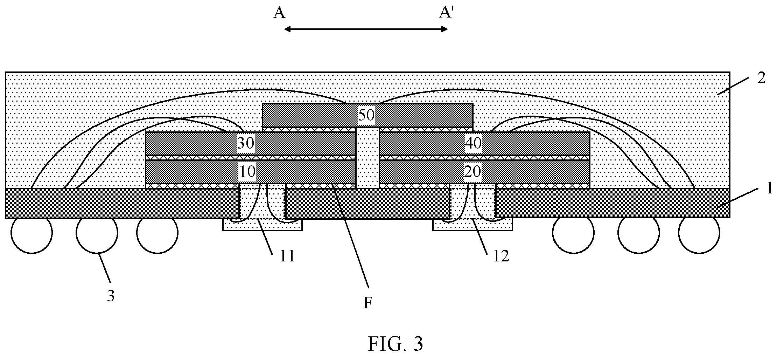

As shown in FIG. 2 and FIG. 3 (a schematic side view of FIG. 2), an embodiment of this application provides a memory chip stacking package, including a substrate 1 and five memory chips sequentially stacked on the substrate 1. The five memory chips are a first memory chip 10, a second memory chip 20, a third memory chip 30, a fourth memory chip 40, and a fifth memory chip 50. In addition, the five memory chips (10, 20, 30, 40, and 50) are distributed at three layers, and contacts are disposed on active surfaces of the five memory chips (10, 20, 30, 40, and 50). FIG. 2 shows the chips in a staggered manner merely for a purpose of clearly illustrating relative locations between the plurality of layers of chips. For an actual relative location relationship between the layers of chips in a horizontal direction, refer to FIG. 3 and the following text descriptions.

As shown in FIG. 3, the first memory chip 10 and the second memory chip 20 are disposed in parallel on an upper surface of the substrate 1 along a first direction AA'. That is, the first memory chip 10 and the second memory chip 20 are located at a first layer of the plurality of layers of memory chips that are sequentially stacked. In some possible implementations, the first memory chip 10 and the second memory chip 20 may be directly attached to the upper surface of the substrate 1 through an attach film (attach film) F.

Herein, it should be noted that, when the memory chips in this embodiment each are the DRAM chip whose contacts are located on the central axis in FIG. 1, with respect to the first direction AA', the first direction AA' may be perpendicular to the central axis of the memory chip (refer to FIG. 2).

As shown in FIG. 3, the active surfaces of the first memory chip 10 and the second memory chip 20 face a side of the substrate 1. That is, the active surfaces of the first memory chip 10 and the second memory chip 20 face down, and non-active surfaces of the first memory chip 10 and the second memory chip 20 face up. Contacts on the active surfaces of the first memory chip 10 and the second memory chip 20 are connected to the substrate 1.

It can be understood that, because the first memory chip 10 and the second memory chip 20 are located on the upper surface of the substrate 1 and the active surfaces of the first memory chip 10 and the second memory chip 20 face the substrate 1, with respect to a manner of connecting the first memory chip 10 and the second memory chip 20 to the substrate 1, a TSV, an RDL, or the like does not need to be used, but a conventional common connection mode (for example, wire bonding or bump-based connection) may be used.

For example, in some possible implementations, as shown in FIG. 3, a first window 11 and a second window 12 for connecting the upper surface and a lower surface of the substrate 1 are provided at locations on the substrate 1 that correspond to the first memory chip 10 and the second memory chip 20 respectively. That is, hollowed-out regions are provided at the locations on the substrate 1 that correspond to the first memory chip 10 and the second memory chip 20 respectively. Contacts on the active surface of the first memory chip 10 are connected to the lower surface of the substrate 1 through wire bonding (wire bonding) and the first window 11, and contacts on the active surface of the second memory chip 20 are connected to the lower surface of the substrate 1 through wire bonding and the second window 12. That is, the first memory chip 10 and the second memory chip 20 that are located at the first layer are connected to the substrate 1 through flip chip window wire bonding (flip chip window wire bonding).

Herein, it can be understood that the first window 11 should be located directly under the contacts of the first memory chip 10 as much as possible, to ensure wire bonding between the first memory chip 10 and the substrate 1, and the second window 12 should be located directly under the contacts of the second memory chip 20 as much as possible, to ensure wire bonding between the second memory chip 20 and the substrate 1.

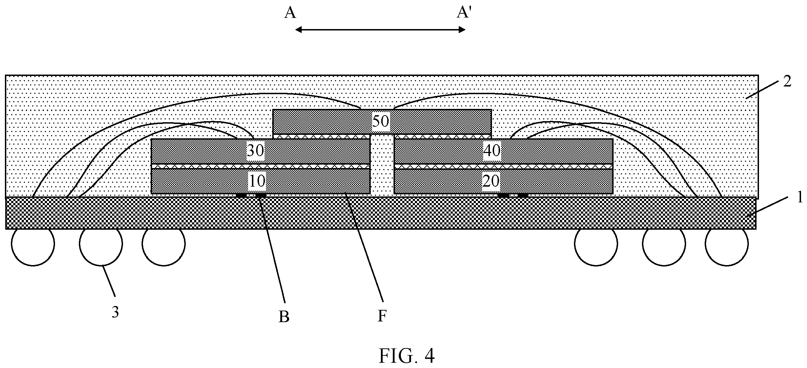

For another example, in some possible implementations, as shown in FIG. 4, the contacts on the active surfaces of the first memory chip 10 and the second memory chip 20 are directly connected to the upper surface of the substrate 1 through bumps (bump) B.

As shown in FIG. 3, the third memory chip 30 and the fourth memory chip 40 are located at a second layer of the plurality of layers of memory chips that are sequentially stacked, the third memory chip 30 is stacked on and attached to the first memory chip 10, and the fourth memory chip 40 is stacked on and attached to the second memory chip 20. Certainly, in this case, the third memory chip 30 and the fourth memory chip 40 are also disposed in parallel along the first direction AA'. In some possible implementations, a non-active surface of the third memory chip 30 may be attached to an upper surface of the first memory chip 10 through an attach film F, and a non-active surface of the fourth memory chip 40 may be attached to an upper surface of the second memory chip 20 through an attach film F.

The active surfaces of the third memory chip 30 and the fourth memory chip 40 face a side away from the substrate 1. That is, the active surfaces of the third memory chip 30 and the fourth memory chip 40 face up, and the non-active surfaces of the third memory chip 30 and the fourth memory chip 40 face down. Contacts on the active surfaces of the third memory chip 30 and the fourth memory chip 40 are connected to the substrate 1 through wire bonding.

As shown in FIG. 3, in some possible implementations, contacts on the active surface of the third memory chip 30 are connected to the upper surface of the substrate 1 through wire bonding, and contacts on the active surface of the fourth memory chip 40 are connected to the upper surface of the substrate 1 through wire bonding. For example, as shown in FIG. 2 and FIG. 3, solder pads (pad) may be disposed in edge regions located on two sides along the first direction on the upper surface of the substrate 1, to ensure that the contacts of the third memory chip 30 and the fourth memory chip 40 are connected to the solder pads on the two sides respectively through wire bonding.

It should be noted that, in FIG. 3 and subsequent accompanying drawings, crossed wire arrangement for the third memory chip 30 and the fourth memory chip 40 is merely an example indicating crossover of wires in space, and the wires are not in direct contact with each other.

In some possible implementations, the contacts on the active surfaces of the third memory chip 30 and the fourth memory chip 40 may be connected to the lower surface of the substrate 1 through wire bonding and windows located at edges of two sides of the substrate 1.

As shown in FIG. 3, the fifth memory chip 50 is located at a third layer of the plurality of layers of chips that are sequentially stacked, and the active surface of the fifth memory chip 50 faces a side away from the substrate 1. That is, the active surface of the fifth memory chip 50 faces up, and a non-active surface of the fifth memory chip 50 faces down. The passive surface of the fifth memory chip 50 is bonded to the active surfaces of the third memory chip 30 and the fourth memory chip 40, and contacts on the active surface of the fifth memory chip 50 are connected to the upper surface of the substrate 1 through wire bonding.

Certainly, to ensure wire bonding between the third memory chip 30 and the substrate 1 and between the fourth memory chip 40 and the substrate 1, the fifth memory chip 50 should not cover the contacts on the active surfaces of the third memory chip 30 and the fourth memory chip 40. For example, the fifth memory chip 50 may be disposed in a region between the contacts on the active surface of the third memory chip 30 and the contacts on the active surface of the fourth memory chip 40, that is, the fifth memory chip 50 overlaps the region between the contacts of the third memory chip 30 and the contacts of the fourth memory chip 40. In some possible implementations, the fifth memory chip 50 may be attached to an upper surface of the region between the contacts of the third memory chip 30 and the contacts of the fourth memory chip 40 through an attach film F.

It can be understood that, to reduce an area of the package structure as much as possible, a gap between the first memory chip 10 and the second memory chip 20 may be reduced as much as possible if a process condition permits. In addition, in some possible implementations, further, an edge of the third memory chip 30 may be arranged to be flush with an edge of the first memory chip 10, and an edge of the fourth memory chip 40 may be arranged to be flush with an edge of the second memory chip 20. That is, orthographic projections of the third memory chip 30 and the first memory chip 10 on the substrate 1 coincide, and orthographic projections of the fourth memory chip 40 and the second memory chip 20 on the substrate 1 coincide.

To sum up, in the memory chip stacking package provided in this embodiment, the five memory chips are stacked at three layers, where the active surfaces of the two memory chips at the first layer are arranged to face down and be directly connected to the substrate (for example, connected to the upper surface of the substrate through bumps, or connected to the lower surface of the substrate through a window on the substrate); the non-active surfaces of the two chips at the second layer are arranged to be respectively attached to the upper surfaces of the two memory chips at the first layer, and the active surfaces of the two chips are arranged to be connected to the substrate through wire bonding (for example, may be connected to the upper surface of the substrate through wire bonding); and the non-active surface of the memory chip at the third layer is arranged to be bonded to the two memory chips at the second layer, and the active surface of the memory chip is arranged to be connected to the upper surface of the substrate through wire bonding. That is, with the memory chip stacking package in this application, on the basis of ensuring that the area of the package structure meets a requirement, interconnection between the five memory chips and the substrate can be implemented without using a connection technology such as micro-bumps in combination with TSVs or an RDL, thereby greatly reducing manufacturing costs of the memory chip stacking package.

### Embodiment 2

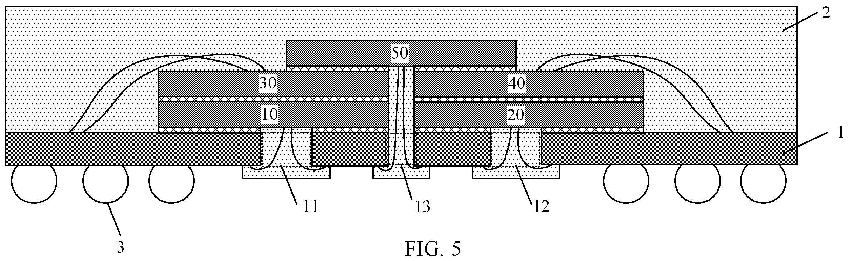

As shown in FIG. 5, a difference between a memory chip stacking package provided in this embodiment and the memory chip stacking package in Embodiment 1 lies in the following:
A third window 13 for connecting the upper surface and the lower surface of the substrate 1 is provided in a region, on the substrate 1, between the first memory chip 10 and the second memory chip 20. In addition, it should be ensured that the third memory chip 30 and the fourth memory chip 40 do not extend above the third window 13. That is, orthographic projections of the third memory chip 30 and the fourth memory chip 40 on the substrate 1 do not overlap the third window 13.

The active surface of the fifth memory chip 50 located at the third layer faces a side of the substrate 1. That is, the active surface of the fifth memory chip 50 faces down, and the non-active surface of the fifth memory chip 50 faces up. The contacts on the active surface of the fifth memory chip 50 are connected to the lower surface of the substrate 1 through wire bonding and the third window 13. It can be understood that, in this case, it should be ensured that the third window 13 is located directly under the contacts of the fifth memory chip 50 as much as possible, to ensure wire bonding between the fifth memory chip 50 and the substrate 1.

In the memory chip stacking package provided in this embodiment, the five memory chips are stacked at three layers, where the active surfaces of the two memory chips at the first layer are arranged to face down and be directly connected to the substrate (for example, connected to the upper surface of the substrate through bumps, or connected to the lower surface of the substrate through a window on the substrate); the non-active surfaces of the two chips at the second layer are arranged to be respectively attached to the upper surfaces of the two memory chips at the first layer, and the active surfaces of the two chips are arranged to be connected to the substrate through wire bonding (for example, may be connected to the upper surface of the substrate through wire bonding); and the non-active surface of the memory chip at the third layer is arranged to be bonded between the two memory chips at the second layer, and the active surface of the memory chip is arranged to be connected to the lower surface of the substrate through wire bonding and a window located on the substrate. That is, with the memory chip stacking package in this embodiment, on the basis of ensuring that the area of the package structure meets a requirement, interconnection between the five memory chips and the substrate can be implemented without using a connection technology such as micro-bumps in combination with TSVs or an RDL, thereby greatly reducing manufacturing costs of the memory chip stacking package.

It should be noted that, in Embodiment 2, to reduce the area of the package structure, a gap between the first memory chip 10 and the second memory chip 20 should be reduced as much as possible on the basis of meeting a process of wire bonding between the fifth memory chip 50 and the lower surface of the substrate 1.

In addition, it should be noted that, compared with Embodiment 1 in which the active surface of the fifth memory chip 50 faces up and therefore a long wire is required for connecting to the solder pads located in the edge regions on the two sides of the upper surface of the substrate 1, in Embodiment 2, the active surface of the fifth memory chip 50 is arranged to face down, and therefore can be connected, by using a short wire through the third window 13, to the lower surface, of the substrate 1, that is located directly under the active surface. In this way, a frequency of a transmitted signal can be effectively increased.

With respect to other related arrangement in the memory chip stacking package in this embodiment, for example, for arrangement of the first memory chip 10, the second memory chip 20, the third memory chip 30, and the fourth memory chip 40, refer to related descriptions in Embodiment 1. Details are not described herein again.

### Embodiment 3

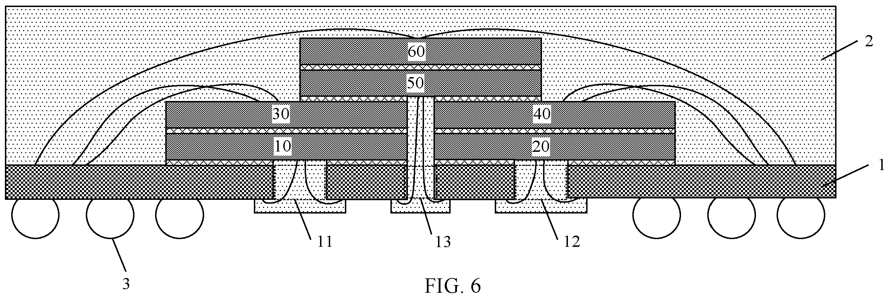

As shown in FIG. 6, a difference between a memory chip stacking package provided in this embodiment and the memory chip stacking package in Embodiment 2 lies in the following:
The memory chip stacking package further includes a sixth memory chip 60 located at a fourth layer. An active surface of the sixth memory chip 60 faces a side away from the substrate 1. That is, the active surface of the sixth memory chip 60 faces up, and a non-active surface of the sixth memory chip 60 faces down. Contacts on the active surface of the sixth memory chip 60 are connected to the upper surface of the substrate 1 through wire bonding.

In some possible implementations, as shown in FIG. 6, the sixth memory chip 60 may be attached to the upper surface of the fifth memory chip 50 through an attach film F.

Certainly, to prevent as far as possible the sixth memory chip 60 from causing unnecessary blocking to other memory chips (30 and 40) at a lower layer in subsequent wire bonding, an edge of the sixth memory chip 60 may be arranged to be flush with an edge of the fifth memory chip 50. That is, orthographic projections of the sixth memory chip 60 and the fifth memory chip 50 on the substrate 1 coincide.

In the memory chip stacking package provided in this embodiment, the six memory chips are stacked at four layers, where the active surfaces of the two memory chips at the first layer are arranged to face down and be directly connected to the substrate (for example, connected to the upper surface of the substrate through bumps, or connected to the lower surface of the substrate through a window on the substrate); the non-active surfaces of the two chips at the second layer are arranged to be respectively attached to the upper surfaces of the two memory chips at the first layer, and the active surfaces of the two chips are arranged to be connected to the substrate through wire bonding (for example, may be connected to the upper surface of the substrate through wire bonding); the non-active surface of the memory chip at the third layer is arranged to be bonded in the region between the contacts of the two memory chips at the second layer, and the active surface of the memory chip is arranged to be connected to the lower surface of the substrate through wire bonding and a window located on the substrate; and the non-active surface of the memory chip located at the fourth layer is arranged to be attached to the upper surface of the memory chip at the third layer, and the active surface of the memory chip is arranged to be connected to the upper surface of the substrate through wire bonding. That is, with the memory chip stacking package in this embodiment, on the basis of ensuring that the area of the package structure meets a requirement, interconnection between the six memory chips and the substrate can be implemented without using a connection technology such as micro-bumps in combination with TSVs or an RDL, thereby greatly reducing manufacturing costs of the memory chip stacking package.

With respect to other related arrangement in the memory chip stacking package in this embodiment, for example, for arrangement of the first memory chip 10, the second memory chip 20, the third memory chip 30, and the fourth memory chip 40, refer to related descriptions in Embodiment 1; and for arrangement of the fifth memory chip 50 and the substrate 1, refer to related descriptions in Embodiment 2. Details are not described herein again.

Based on this, the package structures in Embodiment 1 and Embodiment 2 each include five memory chips, where four memory chips constitute a rank to provide a parallel read/write access function, and the other memory chip may be configured to store an error correcting code (namely, ECC) to implement an error correcting function, that is, the memory chip serves as an ECC memory chip. The package structure in Embodiment 3 includes six memory chips, where four memory chips constitute a rank to provide a parallel read/write access function, one memory chip may be configured to store an error correcting code to implement an error correcting function, and the other memory chip may replace a failed chip, and may replace any other memory chip when the memory chip fails, to provide an error correcting method that cannot be covered by an ECC, that is, implement a chipkill function.

For example, in some possible implementations, when a CPU with a bit width of 64 bits is used in an electronic device and a memory chip stacking package includes five 16-bit memory chips (for example, DDR chips), four of the five memory chips each may provide a 16-bit parallel read/write access function, and the other one may be configured to store an ECC to implement the error correcting function.

With respect to the memory chip stacking package provided in any one of the foregoing possible implementations (including Embodiment 1, Embodiment 2, and Embodiment 3), as shown in FIG. 1, the first memory chip 10 and the second memory chip 20 that are located at the first layer are disposed in parallel along the first direction AA'. In this case, the entire package structure is in a long strip shape (for example, in some embodiments, a size of the package structure is approximately 17.2 mm × 9.5 mm). As a result, stress applied to the first direction AA' and stress applied to a second direction perpendicular to the first direction are unbalanced during installation of the package structure, and a risk of warpage of the entire package structure is likely to occur.

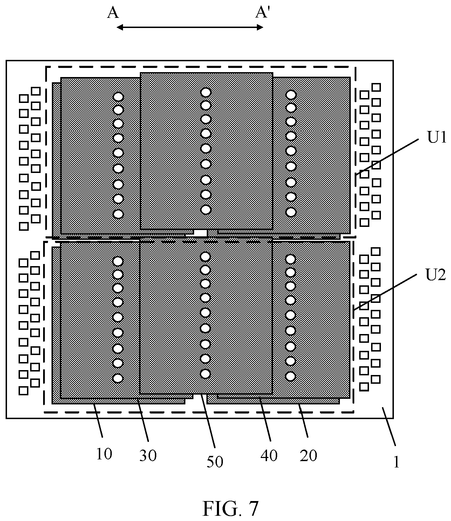

Based on this, the plurality of layers of memory chips that are sequentially stacked on the substrate 1 in the foregoing embodiments are defined as a memory module. As shown in FIG. 7, an embodiment of this application further provides a memory chip stacking package, including two memory modules disposed in parallel along the second direction perpendicular to the first direction AA': a first memory module U1 and a second memory module U2.

In this case, in one aspect, the two memory modules (U1 and U2) are disposed in the package structure, so that the entire package structure can have an approximately square shape (for example, in some embodiments, a size of the package structure is approximately 20 mm × 20 mm), thereby ensuring that stress along the first direction is balanced with that along the second direction during installation of the package structure, and reducing a risk of warpage of the package structure. In another aspect, disposing the two memory modules (U1 and U2) in the package structure is equivalent to packaging two ranks in one package structure, thereby improving integration of the package structure.

In addition, with respect to the first memory module U1 and the second memory module U2 located in the package structure:
In some possible implementations, memory chip arrangement in the first memory module U1 may be exactly the same as that in the second memory module U2. For example, the arrangement manner of the five memory chips in Embodiment 1 may be used for memory chips in the first memory module U1 and the second memory module U2.

In some possible implementations, memory chip arrangement in the first memory module U1 may be partially the same as that in the second memory module U2. For example, the arrangement manner of the five memory chips in Embodiment 1 may be used for the first memory module U1, and the arrangement manner of the six memory chips in Embodiment 3 may be used for the second memory module U2.

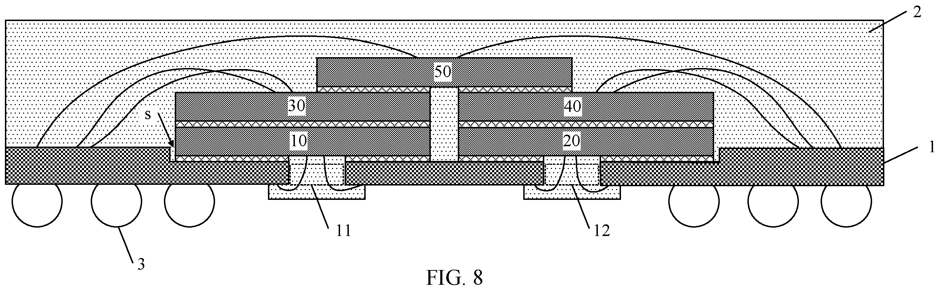

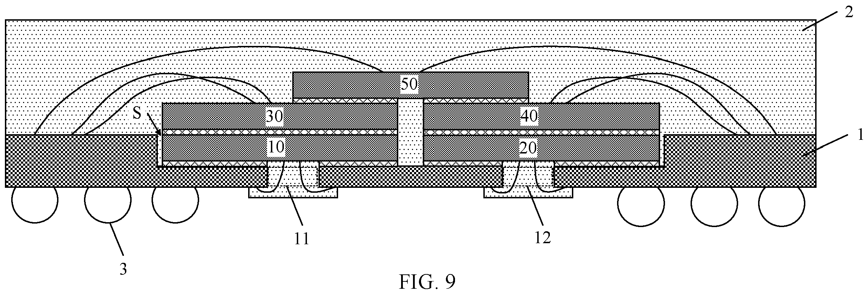

In addition, with respect to the memory chip stacking package provided in any one of the foregoing possible implementations, to reduce a thickness of the entire package structure and reduce lengths of interconnection wires between memory chips located at upper layers (the third layer and the fourth layer) and the substrate for a purpose of reducing a delay of a transmitted signal and ensuring integrity of a high frequency signal, in some possible implementation embodiments, as shown in FIG. 8 and FIG. 9, a groove structure S may be provided on the upper surface of the substrate 1, and memory chips (for example, 10 and 20) located at the first layer may be disposed in the groove structure S, that is, the memory chips located at the first layer may be embedded into the substrate 1.

It should be noted that a depth at which the memory chips at the first layer are embedded into the substrate 1 is not specifically limited in this application. In practice, a manner of embedding the memory chips at the first layer into the substrate 1 may be selected based on thicknesses of the memory chips at the first layer and the substrate 1.

For example, in some possible implementations, as shown in FIG. 8, the memory chips (for example, 10 and 20) at the first layer may be partially embedded into the substrate 1, that is, a depth of the groove structure S on the substrate 1 is less than a thickness of the memory chips at the first layer, and a part of the memory chips at the first layer is exposed out of the groove structure S.

For another example, in some other possible implementations, as shown in FIG. 9, the memory chips (for example, 10 and 20) at the first layer are fully embedded into the substrate 1, and upper surfaces of the memory chips at the first layer are substantially flush with the upper surface of the substrate 1, that is, a depth of the groove structure S on the substrate 1 is basically the same as a thickness of the memory chips at the first layer.

For example, in some embodiments, the memory chips at the first layer may be DRAM chips of approximately 100 µm, and the memory chips at the first layer are fully embedded into the substrate 1. In this case, the thickness of the entire package structure is equivalently reduced by a thickness of one layer of memory chip. For example, a thickness of the memory chip stacking package in Embodiment 1 or Embodiment 2 is equivalent to a thickness obtained by stacking two layers of memory chips on the substrate 1. In addition, a length of a wire between a memory chip at a top layer and the substrate can be reduced

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory chip stacking package, comprising a substrate and a plurality of layers of memory chips sequentially stacked on the substrate, wherein
the plurality of layers of memory chips comprise a first memory chip and a second memory chip that are disposed in parallel at a first layer, a third memory chip and a fourth memory chip that are disposed in parallel at a second layer, and a fifth memory chip located at a third layer;
active surfaces of the first memory chip and the second memory chip face an upper surface of the substrate, and passive surfaces of the third memory chip and the fourth memory chip are attached to passive surfaces of the first memory chip and the second memory chip respectively;
contacts on the active surfaces of the first memory chip and the second memory chip are connected to the substrate;
contacts on active surfaces of the third memory chip and the fourth memory chip are connected to the substrate through wire bonding; and
a passive surface of the fifth memory chip is bonded to the active surfaces of the third memory chip and the fourth memory chip, and contacts on an active surface of the fifth memory chip are connected to the substrate through wire bonding.

2. The memory chip stacking package according to claim 1, wherein
a first window for connecting the upper surface and a lower surface of the substrate is provided at a location, on the substrate, that corresponds to the first memory chip, and a second window for connecting the upper surface and the lower surface of the substrate is provided at a location, on the substrate, that corresponds to the second memory chip; and
contacts on the active surface of the first memory chip are connected to the lower surface of the first substrate through wire bonding and the first window, and contacts on the active surface of the second memory chip are connected to the lower surface of the first substrate through wire bonding and the second window.

3. The memory chip stacking package according to claim 1 or 2, wherein
the contacts on the active surfaces of the third memory chip and the fourth memory chip are connected to the upper surface of the substrate through wire bonding.

4. The memory chip stacking package according to any one of claims 1 to 3, wherein the active surface of the fifth memory chip faces a side away from the substrate, and the contacts on the active surface of the fifth memory chip are connected to the upper surface of the substrate through wire bonding.

5. The memory chip stacking package according to any one of claims 1 to 3, wherein the active surface of the fifth memory chip faces the upper surface of the substrate, a third window for connecting the upper surface and the lower surface of the substrate is provided in a region, on the substrate, that corresponds to the first memory chip and the second memory chip;
orthographic projections of the third memory chip and the fourth memory chip on the substrate do not overlap the third window; and
the contacts on the active surface of the fifth memory chip are connected to the lower surface of the substrate through wire bonding and the third window.

6. The memory chip stacking package according to claim 5, wherein
the plurality of layers of memory chips further comprise a sixth memory chip located at a fourth layer; and
an active surface of the sixth memory chip faces a side away from the substrate, and contacts on the active surface of the sixth memory chip are connected to the upper surface of the substrate through wire bonding.

7. The memory chip stacking package according to any one of claims 1 to 6, wherein orthographic projections of the third memory chip and the first memory chip on the substrate coincide, and orthographic projections of the fourth memory chip and the second memory chip on the substrate coincide.

8. The memory chip stacking package according to claim 6 or 7, wherein orthographic projections of the sixth memory chip and the fifth memory chip on the substrate coincide.

9. The memory chip stacking package according to any one of claims 1 to 8, wherein
all the memory chips in the memory chip stacking package have same specifications, and contacts of each memory chip are located on a central axis of an active surface.

10. The memory chip stacking package according to any one of claims 1 to 9, wherein
all the memory chips in the memory chip stacking package are DRAM chips.

11. The memory chip stacking package according to any one of claims 1 to 10, wherein
the plurality of layers of memory chips sequentially stacked on the substrate constitute a memory module, and the first memory chip and the second memory chip in the memory module are disposed in parallel along a first direction;
the memory chip stacking package comprises two memory modules disposed in parallel along a second direction; and
the second direction is perpendicular to the first direction.

12. The memory chip stacking package according to any one of claims 1 to 11, wherein a groove structure is provided on the upper surface of the substrate, and all the memory chips located at the first layer are disposed in the groove structure.

13. The memory chip stacking package according to any one of claims 1 to 12, wherein four of the first memory chip, the second memory chip, the third memory chip, the fourth memory chip, and the fifth memory chip are configured to provide a parallel read/write access function, and the remaining one is configured to store an ECC to implement an error correcting function.

14. An electronic device, comprising a CPU and the memory chip stacking package according to any one of claims 1 to 13, wherein the memory chip stacking package is connected to the CPU.

15. The electronic device according to claim 14, wherein a bit width of the CPU is 64 bits, four of the first memory chip, the second memory chip, the third memory chip, the fourth memory chip, and the fifth memory chip each are configured to provide a 16-bit parallel read/write access function, and the remaining one is configured to store an ECC to implement an error correcting function.
